Europäisches Patentamt

**European Patent Office**

**Office européen des brevets**

(11) Publication number: **0 285 051 B1**

## EUROPEAN PATENT SPECIFICATION

(45) Date of publication of patent specification: **23.06.93**  (51) Int. Cl.⁵: **H01L 21/58**, H01L 21/60

(21) Application number: **88104940.7**

(22) Date of filing: **26.03.88**

(54) **Method for bonding integrated circuit chips.**

(30) Priority: **30.03.87 US 31793**
**21.08.87 US 88141**

(43) Date of publication of application:
**05.10.88 Bulletin  88/40**

(45) Publication of the grant of the patent:
**23.06.93 Bulletin  93/25**

(84) Designated Contracting States:
**BE CH DE FR GB IT LI LU NL SE**

(56) References cited:
**EP-A- 0 051 165       EP-A- 0 135 416**
**EP-A- 0 142 783       EP-A- 0 198 194**
**EP-A- 0 215 502       US-A- 3 494 017**
**US-A- 4 029 628**

(73) Proprietor: **E.I. DU PONT DE NEMOURS AND COMPANY**
**1007 Market Street**
**Wilmington Delaware 19898(US)**

(72) Inventor: **Graham, William Frank**
**8 Briarwood Court**
**Landenberg, PA 19350(US)**
Inventor: **Lofurno, Mel Augustine**
**207 Partridge Way**
**Kennett Square, PA 19348(US)**
Inventor: **Sakiadis, Byron Christos**
**R.D. 1, Box 430**
**Chadds Ford PA 19317(US)**

(74) Representative: **von Kreisler, Alek, Dipl.-Chem. et al**
**Deichmannhaus am Hauptbahnhof**
**W-5000 Köln 1 (DE)**

## Description

The Field of Invention

The invention relates to a method for bonding integrated circuit chips to substrates such as lead frames.

Background of the Invention

In the mass production of integrated chip assemblies, a particularly critical step to productivity of the process is the step of bonding the integrated circuit (IC) chip to its substrate. Such substrates include lead frames, MLC chips, diodes, quartz crystals and the like. Heretofore, this has been done either by bonding the IC chip by means of a eutectic process, inorganic binder or by means of a filled epoxy adhesive. In the latter two cases, the assembly must be removed from the assembly line and processed further in some way. For example, in the case of inorganic binders, the assembly must be fired off-line to effect sintering of the inorganic binder and bonding of the IC chip to the substrate, thus removing the part from the assembly sequence for up to two hours typically and frequently longer. Similarly, in the case of filled epoxy binders, the assembly must be removed from the assembly sequence to allow curing (crosslinking) of the epoxy resin, which may require from several minutes to as much as an hour for completion.

From the foregoing description of the current state of the art, it is evident that there is a very substantial unmet need for a method of bonding IC chips to substrates by which appropriate adhesion of the IC chip to the substrate can be achieved so quickly that "in-line" assembly is possible. The primary objectives of such a process would be to have a bonding system that would result in higher throughput, higher yields, improved device reliability and effectively lower cost.

To achieve these primary objectives, it is necessary that the bonding system meet the secondary objectives of being adaptable to a highly automated in-line process (eliminating off-line processing altogether) by which the mounted IC chip can be conveyed directly and immediately to wire bonding.

Prior Art

U.S. 3,446,654, Barth et al.

Thermoplastic polyarylene polyethers containing conductive materials and selected salts for use as conductive adhesives.

U.S. 3,772,248, Brown et al.

Fluoroaliphatic-linked polyether (polyarylsulfones) are disclosed to be good adhesives with or without fillers.

U.S. 3,926,916, Mastrangelo

Dielectric compositions comprising dielectric polymeric binder and aluminum particles, the surfaces of which are oxidized.

U.S. 3,978,378, Tigner et al.

Addition of at least 50% vol. copper and alkali metal salt to make resin compositions electroconductive.

U.S. 4,233,103, Shaheen

Mixture of polyimide resin and an alloy of Ga/Sn eutectic and Au as a die attach adhesive and method for bonding a semiconductor to a substrate.

U.S. 4,377,652, Ohumra et al.

Use of aromatic polyamide-imide as adhesive for electrical components.

U.S. 4,395,527, 4,480,009 and 4,499,149, Beyer

Die adhesive consisting of a polyimide having heat-resistant polysiloxane units with particles of electrically conductive material dispersed therein.

EP 14-599 (M&T Chemicals, Inc.)

Aromatic silicone compounds useful as coatings for semiconductor devices.

EP 51-165, Burroughs Corp.

IC package bonded to a substrate with thermoplastic polymer. Several polymers are mentioned including polyethylene and polypropylene.

EP 90-151, American Cyanamid

Composites for use as conductive adhesive comprising polymer and metal-coated fibers having an electrically conductive non-metallic core.

EP 163-518A (M&T Chemicals, Inc.)

Thermoplastic heat-stable polyamide acid, polyimide, poly(amide-imide), poly(ester-imide) and poly (amide-imide) polymers for use as coatings on electronic components.

Japanese Pat. Appln. 51-04007, Kokuku Rubber KK

Bonding material for electronic components comprising conductive particles dispersed in an elastomeric polymer matrix.

Hanai et al., Heat Resistant Materials for Electric and Electronic Uses, Yuki Gosei KK, Shi 42, No. 11:1074-80 (1984)

Discussion of polyetheretherketone, polyimide and inorganic polymers as heat-resistant polymeric materials for electric and electronic uses.

Summary of the Invention

The invention is directed to a method for attaching an integrated circuit chip to a mating surface of a high surface energy substrate by means, of a layer of a thermoplastic organic polymer comprising the sequential steps of:
(1) Forming a continuous filament of non-olefinic, substantially amorphous solvent-free thermoplastic polymer, at least one dimension of which is substantially equal to or greater than a lateral dimension of the integrated circuit chip, the polymer being further characterized in that
the glass transition temperature $T_g$ is at least 30 °C,
the embrittlement temperature $T_b$ is below -30 °C,
the equilibrium water absorption measured at 23 °C for 24 hours $S_w$ is less than 1.0 % wt., and
Extractable ionics are less than 10 ppm by wt.;
(2) Cutting the filament to form an adhesive pad having both lateral dimensions substantially equal to or greater than the lateral dimensions of the integrated circuit chip and having a thickness of 25-125 $\mu$m;
(3) Simultaneously preheating the surfaces of both the substrate and the integrated circuit chip so that the temperature of at least one of the surfaces exceeds the Tg of the amorphous adhesive;
(4) Positioning the adhesive pad upon the heated substrate surface with the application of slight pressure to effect heat transfer from the substrate to the adhesive pad, thus softening the adhesive without incurring adhesive flow;
(5) Positioning the integrated circuit chip upon the heated adhesive pad;
(6) Laminating the integrated circuit chip to the substrate by applying a higher pressure to the integrated circuit chip to reduce the thickness of the adhesive pad by 0.5 to 5% within 5 seconds; and
(7) Releasing the pressure on the integrated circuit chip and cooling the laminated chip assembly.

3

Brief Description of the Drawing

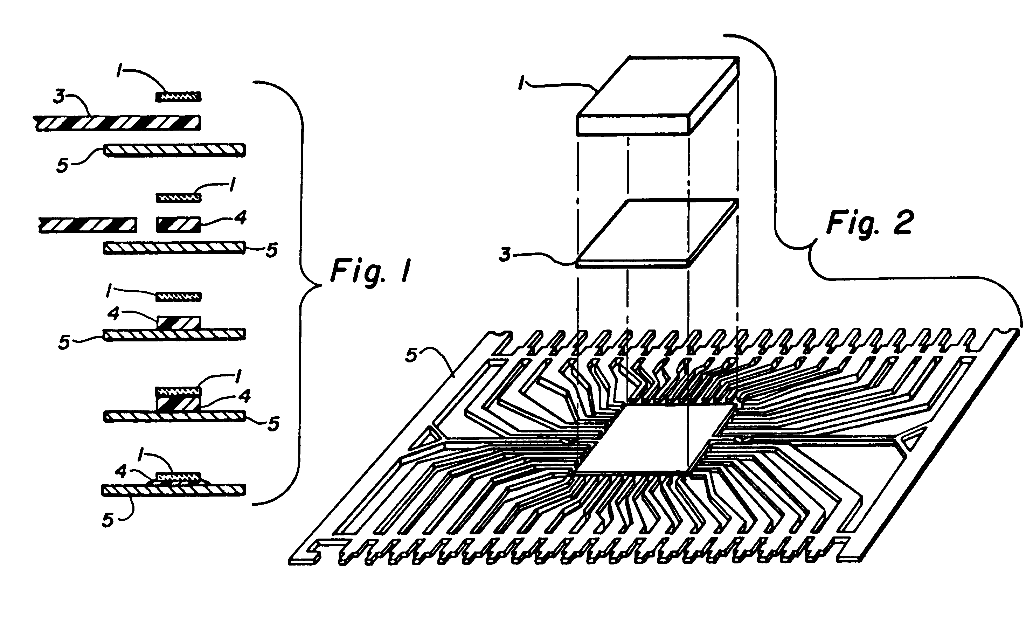

The drawing consists of two figures, of which FIG.. 1 is an exploded view of an integrated chip assembly which has been assembled by the method of the invention and FIG. 2 is a schematic representation of the manipulative steps of the method of the invention.

Detailed Description of the Drawing

Referring now to FIG. 1 of the drawing, which is a schematic exploded view of an integrated circuit chip assembly upon a metal lead frame substrate. In particular, adhesive pad 3 is interposed between the upper surface of metal lead frame 7 within chip positioning area 5 and the lower surface of the IC chip 1.

Now referring to FIG. 2 of the drawing, which is a schematic representation of the steps of the method of the invention, a continuous filament of non-olefinic substantially amorphous solvent-free thermoplastic polymer as characterized hereinabove having a ribbon configuration in which the width of the ribbon 3 is approximately the same as the width of one of the sides of a rectangular IC chip 1. This ribbon 3 is then cut to a length which is approximately the same as the other side of the IC chip. The ribbon thickness is between 25 and 125 $\mu$m (microns).

At the same time, the surfaces of both the IC chip 1 and the lead frame substrate 5 are heated so that the surface temperature of at least one of them facing the adhesive pad 4 exceeds the glass transition temperature ($T_g$) of the adhesive. A mechanical gripping device, not shown, then places the adhesive pad 4 upon the heated surface of the lead frame substrate and applies a slight pressure to secure placement of the pad 4 and to effect transfer of heat from the substrate 5 by which the adhesive is softened, but not so that any appreciable adhesive flow will take place. Integrated circuit chip 1 is then placed by mechanical means atop the adhesive pad 4 and laminated thereto by applying a higher pressure to the IC chip 1 sufficient to reduce the thickness of the adhesive pad 4 by 0.5 to 5% within an interval of 5 seconds, and preferably about 1% in 2 seconds or less. When lamination is complete, pressure on the IC chip 1 is released and the laminated assembly is cooled. The lead frame 5 having the IC chip 1 laminated thereto is then conveyed to another position for further processing such as wire bonding and the insertion of other functional electronic parts.

Detailed Description of the Invention

A. Adhesive Material

The adhesive materials which are suitable for use in the invention are non-olefinic, predominantly amorphous, substantially solvent-free thermoplastic polymers having the following essential properties:
$T_g$ is at least 30°C and preferably at least 50°C,
$T_b$ is below -30°C,
$S_w$ is less then 1.0% wt., and
Extractable ionics are less than 10 ppm by weight.
Each of these properties is necessary to obtain uniformly the essential properties of rapid bonding, adequate bonding (adhesion) strength and low degree of change upon aging and extended use.

As a practical matter, the maximum $T_g$ of polymers which is likely to be useful in the process is 300-400°C. Polymers having higher $T_g$ are, of course, more difficult to heat to the appropriate viscosity for binding.

Non-olefinicity of the material is required to obtain good adhesion to high surface energy substrates, such as metals, alumina and silica. On the other hand, both the $T_g$ and $T_b$ limitations are necessary to give the proper rheology for fast, strong bonding at high application temperatures. The limits on water absorption and extractable ionics are essential to assure that the bond between these materials and the substrate is not degraded over long periods of time.

A wide variety of non-olefinic polymeric materials are available which may possess properties which meet the above-referred criteria such as polyarylates, polyetheretherketones, polyetherketoneketones, polyetherimides, nylon polymers and copolymers, polycarbonates, polyphenyleneoxides, polyesters and copolyesters, acrylic and methacrylic polymers and copolymers, copolymers of butadiene and styrene, copolymers of butadiene and acrylonitrile, copolymers of butadiene and acrylates or methacrylates, copolymers of styrene and acrylates or methacrylates and compatible mixtures thereof. As used herein, the term "copolymer" includes not only bipolymers but terpolymers and other multipolymers.

4

From this list, it can be seen that the chemical composition of the polymer is not by itself critical so long as the polymer, either with or without filler, meets all of the above-referred criteria.

It is also necessary that the adhesives used in the invention contain no substantial amounts of volatile solvents. Thus to avoid formation of bubbles and voids during the hot bonding process, the amount of such solvents should be less than about 5% wt. and preferably no more than 1% wt. or even less. Such low solvent content is also preferred to ensure that the adhesive is non-tacky at room temperature.

Furthermore, it is necessary that the adhesive for use in the invention be amorphous, i.e., non-crystalline, because of the tendency of highly crystalline polymers to shrink away from the substrate upon cooling.

It will be recognized that in many applications it may be desirable to make the adhesive used in the process more thermally conductive or more electrically conductive. This can be done by the addition of finely divided particles of conductive metals such as Ag, Au, Cu, Pd/Ag, Ni and the like. While substantial amounts of these metals may be added to the adhesive polymers, it is nevertheless recognized that they should not exceed 50% by volume of the total adhesive and preferably 30% or less. If more than about 50% of filler is used, degradation of the strength properties is likely to be excessive.

The polymeric adhesive material is formed, either filled or unfilled, in a filamentary form such that with a single cut it can be formed into a pad of appropriate size to adhere the IC chip. Thus, the adhesive may be in the form of a thin ribbon which is approximately as wide as the part to be adhered and which then can be cut to length in a single cutting action to form a "pad" which approximates the other dimension of the IC chip to be bonded. Similarly, the adhesive can be formed as a monofilament having about the same cross-section as the lateral edges of the chip to be bonded. This filament can then be sliced to appropriate thickness and used in the process. Another form can be a thin filament for use in bonding very small IC's <1270 $\mu$m (<50 mils) by softening the tip of the filament and transferring a small amount of the polymer by bringing it into contact with the substrate.

The thickness of the adhesive must, of course, be sufficient to provide enough adhesive strength for effective bonding However, if the adhesive exceeds about 127 $\mu$m (5 mils) in thickness, it is too slow to bond and if it is less than 25 $\mu$m (1 mil) in thickness, the adhesive is difficult to handle and placement is particularly difficult. Thus a ribbon thickness of 25-50 $\mu$m (1-2 mils) is preferred which provides a quite adequate amount of adhesive to form a strong bond between the IC chip and the substrate. In any event, the thickness of the cut adhesive pad should be on the order of 25-125 $\mu$m, 25-50 $\mu$m being preferred.

In most instances, it is preferred that the adhesive pad be approximately the same size as the chip to be bonded, or perhaps slightly larger. However, it is obvious that the relative size of the pad is not narrowly critical so long as there are sufficient adhesive to present strong bonding. Thus the surface area of the adhesive pad should be at least about 80% and preferably about 90% or more of the surface area of the piece being bonded.

The adhesive used in the method of the invention can be formed into its appropriate approximate shape by the usual prior art method such as solvent casting and by melt extrusion. A suitable method for tape casting is illustrated in U.S. Patents 4,536,535 and 4,613,648 to Usala. Upon completion of casting, sheets of the material are then slit to appropriate width and the resultant ribbons are wound on spools for use.

B. Substrate

The method of the invention can be used to bond IC chips to virtually any kind of high surface energy substrate. Thus, the invention can be used on organic substrates as well as ceramic, metal and metal core substrates.

Organic substrates are made from such materials as epoxy-impregnated paper and glass fibers, phenolic and resin-impregnated and paper and polyimide resins, all of which may be laminated with copper foil.

Ceramic substrates are generally ceramic oxides of which $Al_2O_3$ and $SiO_2$ predominate. However, previously fired patterned substrates such as those laid down from screen-printed conductor, resistor and dielectric thick films and from green tapes may also be used. Other ceramic substrate materials include BeO, AlN and metal core substrates such as porcelain enamelled steel. One of the most widespread uses of the invention will be to bond IC chips to metal lead frames.

All of these substrates are characterized by high energy surfaces which are wetted by the non-olefinic polymeric materials used in the invention.

C. Process Parameters

In carrying out the process of the invention, any conventional ribbon feeder can be used which has been adapted to provide suitable means for feeding and cutting the adhesive ribbon. Ribbon feeders of this type are frequently used for die attachment in the electronics industry.

In conventional ribbon feeders, the die attach pickup "head" is comprised of an open-ended tube which picks up the cut adhesive ribbon by means of vacuum applied to the tube. The application of a vacuum in this manner tends to deform the pad as it is placed on the substrate. Therefore, to avoid this problem, applicants have devised modified vacuum pick-up heads with porous tips. By this means, the vacuum is applied more evenly across the entire area of the pad and the pad bearing surface is increased, therefore, virtually no distortion of the pad takes place.

In preheating the surface of the substrate and the IC chip preparatory to positioning the adhesive pad on the substrate, it is not necessary that both surfaces be heated above the $T_g$ of the adhesive. It is sufficient that only one of them be so heated. However, in some instances, it may be preferred to heat both surfaces to such a level in order to speed up the bonding process. It is not necessary that the adhesive material be heated substantially above its $T_g$ since it is not desired that the adhesive undergo any flow until the laminating step of the process.

When the adhesive pad is placed on the heated substrate, it is necessary that it undergo a slight pressure to ensure that it will remain in place as it is positioned. The slight pressure facilitates initial heat transfer from the heated substrate to the adhesive material and thus the surface of the adhesive becomes tacky very rapidly.

The heat transfer process between the substrate and the pad and between the IC chip and the pad continues as laminating pressure is applied to the assemblage. This results in some flow of the adhesive by which the thickness of the adhesive pad is reduced by 0.5-5% within a very short dwell time, which is always 5 seconds or less and usually 2 seconds or less. For most production lines, it will be preferred to use operating conditions that permit the bonding operation to be applied within 1 second.

It is sometimes prefered that the laminating step include a gentle, patterned scrubbing action which enhances both the rate of heat transfer, substrate wetting and the strength of the adhesive bond.

Upon completion of the lamination step, the bonded chip is cooled. No special cooling process is needed for this. Ambient air cooling is sufficient.

Abbreviations and Definitions

$T_g$   Glass transition temperature
$T_b$   Embrittlement temperature, i.e., the temperature at which the material behavior changes from ductile to brittle. Brittle behavior is characterized by materials which have an elongation-at-break of less than about 2%.
$S_w$   Equilibrium water absorption measured at 23°C for 24 hours.
As used herein, the term "amorphous polymer" refers to polymers having less than 50% crystallinity.

Test Procedures

Tensile Modulus - ASTM Test D882

Other tensile measurements were made using an Instron® tester at a pull rate of 0.0125 mm/mm•minute (0.0125 inches per inch.minute) at room temperature. Test specimens were (0.25 x 4 inch) 0.6 x 10 cm strips cut from larger material sheets.

Extractable ionics were determined by immersing the adhesive specimen in deionized water for 20 hours at either 100°C or 120°C and then analyzing the extract for Na, K, $NH_4$, Cl and $SO_4$ ions.

Water Absorption ($S_w$) - ASTM Test D570 (24 hrs. at 22°C (73°F))
Melting Temperature ($T_m$) - Differential Scanning Calorimeter (DSC)
Glass Transition Temperature ($T_g$) - Differential Scanning Calorimeter, cooling cycle or mechanical spectrometer, tan delta
Melt Viscosity - Rigid Polymers - Instron® Rheometer Compliant Polymers - Compression Flow Test

The invention can perhaps be further understood by reference to the following examples:

EXAMPLES

Examples 1-6

A series of six adhesive ribbons was prepared in which filled and unfilled strips of two low molecular weight polymers and one high molecular weight polymer were tested as to their tensile properties. All tensile tests were conducted on (0.25 x 4 inch) 6.4 x 10.2 cm long ribbons cut from a larger sheet of material. The results of the tests are shown in Table 1 which follows:

## TABLE 1

## Tensile Properties of Adhesive Pads

| Example | 1 | 2 | 3 | 4 | 5 | 6 |
|---|---|---|---|---|---|---|
| Polymer | Poly-ether-imide | Poly-ether-imide | Acrylic resin | Acrylic resin | Acrylic resin | Acrylic resin |
| Filler | None | 30% v.Ag. | None | 30% v.Ag. | None | 30% v.Ag. |
| Tensile Modulus (1) (x $10^5$ psi) x $10^4$ bar | (4.0) 2.76 | (10.9) 7.52 | (0.5) 0.34 | (1.3) 0.89 | (1.0) 0.68 | (3.4) 2.34 |
| Film Thick. (Mils) $\mu m$ | (2.0) 51 | (1.0) 25 | (1.8) 46 | (2.2) 56 | (1.6) 41 | (2.0) 51 |
| Yield % | – | – | 3.0 | 1.3 | 2.0 | 1.2 |
| Recovery (2) | 94 | – | 50 | 45 | 50 | – |
| Elongatn. at Break % | – | 1.2 | – | – | – | 1–7 |
| Stretch % | – | – | 10 | 10 | 5 | – |

(1) 1/2% stretch at 0.125 mm/mm·minute [0.125 in/(in.minute)] stretch rate.
(2) After 2% stretch.

The data in Table 1 show that the tensile modulus of the silver-filled adhesive strips was about three times the modulus of the unfilled materials. This was true of both of the stiff polymers (unfilled modulus $2.07 \times 10^4$ bar ($3 \times 10^5$ psi) and the compliant polymers (unfilled modulus $2.07 \times 10^4$ bar ($3 \times 10^5$ psi).

The stiffer poly(etherimide) strips exhibited the highest modulus while the acrylics exhibited lower modulus. The stiffer, i.e., more non-compliant polymers, showed high recovery and low elongation at break, while the more compliant acrylic polymers showed low yield and recovery but high stretchability. Compatible blends of stiff and compliant polymers can be used to obtain a more optimum combination of properties.

Examples 7-12

The following examples illustrate the operating conditions which have been used in field tests of die bonding with various filled and unfilled adhesives in accordance with the invention. The composition of the adhesives and the bonding conditions are summarized in Table 2 which follows:

## TABLE 2

### BONDING CONDITIONS FOR FIELD TEST DIE BONDING

| Example | 7 | 8 | 9 |
|---|---|---|---|
| Composition | 30% Ag-filled Polyetherimide | 30% Ag-filled Polyacrylate | Unfilled Polyethylene Terephthalate |
| Ribbon Dimension | | | |
| Thickness, (Mil) $\mu m$ | (1.7) 43 | (2.0 avg.) 51 | (1.0) 25 |
| Width, (Mil) $\mu m$ | (126) 3 200 | (145) 3 683 | Die +(6 Mil) 142 |
| Length, (Mil) $\mu m$ | (83) 2 108 | (145) 3 683 | Die +(6 Mil) 142 |
| Thermal Conditions, Heater Block Surface Temperature °C | 450 | 400 | 315 |
| Die Temperature (Estimated), °C | 100 | 100 | 100 |
| Bonding Time, Seconds | 1 | 2 | 1 |
| Load, g | 100 | 100 | 60 |
| Scrubbing | Yes | No | No |

8

EP 0 285 051 B1

| Example | 10 | 11 | 12 |
|---|---|---|---|
| Composition | Unfilled Poly-Ethyleneterephthalate | Unfilled Polyetherimide | 15% Ag-Filled Polyetherimide |
| Ribbon Dimension | | | |
| Thickness, (Mil) μm | (2.0) 51 | (2.0) 51 | (2.0) 51 |
| Width, (Mil) μm | Die + (6 Mil) 142 | Die + (6 Mil) 142 | Die + (6 Mil) 142 |
| Length, (Mil) μm | Die + (6 Mil) 142 | Die + (6 Mil) 142 | Die + (6 Mil) 142 |
| Thermal Conditions, Heater Block Surface Temperature °C | 315 | 405 | 410 |
| Die Temperature (Estimated) °C | 100 | 100 | 100 |
| Bonding Time, Seconds | 1 | 2 | 2 |
| Load, g | 60 | 100 | 100 |
| Scrubbing | No | Yes | Yes |

Heating the Lead Frame: In the foregoing Examples 7-12, the metal lead frame substrate was heated by bringing it into contact with a heating block maintained at a constant high temperature. In this procedure, one surface of the frame contacts the heating block while the other surface is exposed to ambient temperature. At these conditions, a copper or silver lead frame (10 mils) 254 μm thick can be heated from 23°C to within 10°C of a heating block temperature of 450°C in less than 0.001 seconds. This holds true if there is no resistance to heat flow at the heating block-lead frame interface. In practice, there will always be a contact resistance at that interface. However, this resistance is minimized by pressing the lead frame against the heating block surface to eliminate any air film at the interface. In view of these considerations, it is reasonable to estimate an actual heating time for the lead frame of less than, say, 0.01 seconds for a wide range of specified bonding temperatures up to 450°C.

Heating the Adhesive - Transient heat transfer computations for heating the adhesive placed cold (23°C) on a hot lead frame show that the adhesive temperature will be within 10°C of the lead frame temperature in less than 0.09 seconds. This holds true for a typical potential unfilled adhesive bit 62.5 μm (2.5 mils) or less, thick placed on a block heated up to 450°C.

Combining the results obtained above with those of the lead frame heating step, it is clear that the lead frame and unfilled adhesive 62.5 μm (2.5 mils) or less thick) can be heated from room temperature to the desired temperature in less than about 0.1 seconds.

Heating the IC Chip: In practice, it has been found to be difficult to heat the IC chip by conduction from a large heated mass because of the very small heat transfer surface presented by the collet which holds the chip for bonding. It is therefore preferred to heat the IC chip by direct contact with a heated block or by hot air flow over the chip before contacting the adhesive.

Transient heat transfer computations for heating a silica die, (21 mils) thick 533 μm, from, say 100°C to within 10°C of a heating block maintained at 450°C yield a heating time of 0.75 seconds. This holds true if heat flow from the heating block to the die surface is unrestricted. Considering the resistance to heat flow due to the intervening adhesive ((2.5 mils) 64 μm thick) increases the die heating time to 1.7 seconds. In the above calculations, the assumption was made that the die collet does some heating of the die, raising its temperature to 100°C. If this temperature can be increased by collet heating, then the die heating time will be less than 1.7 seconds.

The results of of the transient heat transfer computations discussed above can be summarized as follows:

9

| Process | Heating Time |
|---|---|
| Heating of Copper or Silver Lead Frame (254 $\mu$m (10 mils) thick) | 0.01 seconds |
| Heating of Adhesive (62.5 $\mu$m (2.5 mils) thick) | 0.09 seconds |
| Heating of Die from Heating Block (533 $\mu$m (21 mils thick)) | 1.7 seconds |
| Total Heating Time | 1.8 seconds |

The above total heating time of 1.8 seconds applies to heating all three components, lead frame, adhesive and die, from 23°C up to 450°C. This calculated heating time is a maximum time because die heating, which accounts for most of the total heating time, need not continue until the die is heated to 450°C. This is obviously the case because bonding takes place at the die surface through which heat flows from the heating block. Furthermore, it is undesirable to heat the entire die to such high temperature. From these computations, it is quite clear that total heating times for assembly of all the three components would be about 1 second when only a portion of the die is heated to near bonding temperature.

**Claims**

1. A method for attaching an integrated circuit chap to a mating surface of a high surface energy substrate by means of a layer of a thermoplastic organic polymer comprising the sequential steps of:

(1) Forming a continuous filament of non-olefinic, substantially amorphous solvent-free thermoplastic polymer, at least one dimension of which is substantially equal to or greater than a lateral dimension of the integrated circuit chip, the polymer being further characterized in that

the glass transition temperature $T_g$ is at least 30 °C,

the embrittlement temperature $T_b$ is below -30 °C,

the equilibrium water absorption measured at 23 °C for 24 hours $S_w$ is less than 1.0 % wt., and

Extractable ionics are less than 10 ppm by wt.;

(2) Cutting the filament to form an adhesive pad having both lateral dimensions substantially equal to or greater than the lateral dimensions of the integrated circuit chip and having a thickness of 25-125 $\mu$m;

(3) Simultaneously preheating the surfaces of both the substrate and the integrated circuit chip so that the temperature of at least one of the surfaces exceeds the Tg of the amorphous adhesive;

(4) Positioning the adhesive pad upon the heated substrate surface with the application of slight pressure to effect heat transfer from the substrate to the adhesive pad, thus softening the adhesive without incurring adhesive flow;

(5) Positioning the integrated circuit chip upon the heated adhesive pad;

(6) Laminating the integrated circuit chip to the substrate by applying a higher pressure to the integrated circuit chip to reduce the thickness of the adhesive pad by 0.5 to 5% within 5 seconds; and

(7) Releasing the pressure on the integrated circuit chip and cooling the laminated chip assembly.

2. The method of claim 1 in which the adhesive pad is subjected to a patterned scrubbing action during step (6).

3. The method of claim 1 in which the substrate and integrated circuit chip are heated by direct heat transfer from inert hot gases.

4. The method of claim 1 in which a metallic lead frame is used as the substrate.

5. The method of claim 1 in which a ceramic oxide is used as the substrate.

6. The method of claim 5 in which alumina is used as the ceramic oxide.

7. The method of claim 1 in which an organic polymer is used as the substrate.

8. The method of claim 7 in which a glass-filled epoxy polymer is used as the substrate.

9. The method of claim 1 in which the adhesive is comprised of a compliant polymer having a low unfilled tensile modulus, $T_g$ below 140°C and viscosity of less than 1M Pa.s at the lamination temperature.

**10.** The method of claim 1 in which the adhesive is comprised of a rigid polymer having a high unfilled tensile modulus, $T_g$ at least 140°C, $T_m$ at least 230°C and viscosity of less than 5000 Pa.s at the lamination temperature.

**11.** The method of claims 9 and 10 in which the adhesive is comprised of a mixture of compliant and rigid polymers.

**12.** The method of claim 1 in which the adhesive is filled with finely divided particles smaller than 127 $\mu$m (5 mils) heat-conductive solids.

**13.** The method of claim 12 in which the heat conductive solids is metallic silver.

**14.** The method of claim 1 in which the adhesive is selected from polyarylates, polyetheretherketones, polyetherketoneketones, polyetherimides, nylon polymers and copolymers, polycarbonates, polyphenyleneoxides, polyesters and copolymers, copolymers of butadiene and styrene, copolymers of butadiene and acrylonitirile, copolymers of butadiene and acrylates or methacrylates, copolymers of styrene and acrylates or methacrylates and compatible mixtures thereof.

**Patentansprüche**

**1.** Verfahren zum Befestigen eines Chips mit einer integrierten Schaltung an einer dazu passenden Oberfläche eines Substrats mit einer hohen Oberflächenenergie mittels einer Schicht aus einem thermoplastischen organischen Polymer, umfassend die aufeinanderfolgenden Schritte

(1) des Bildens eines Endlos-Filaments aus einem nicht-olefinischen, im wesentlichen amorphen, lösungsmittelfreien thermoplastischen Polymer, von dem wenigstens die Abmessung in einer Richtung im wesentlichen gleich einer seitlichen Abmessung des Chips mit der integrierten Schaltung oder größer als dieser ist, wobei das Polymer weiterhin dadurch gekennzeichnet ist, daß die Glasübergangs-Temperatur $T_g$ wenigstens 30 °C beträgt, die Versprödungs-Temperatur $T_b$ unterhalb von -30 °C liegt, die 24 h bei 23 °C gemessene Gleichgewichts-Wasseraufnahme $S_w$ kleiner als 1 Gew.-% ist und extrahierbare ionische Anteile unter 10 ppm, bezogen auf das Gewicht, liegen;

(2) des Zerschneidens des Filaments zur Bildung einer Klebeauflage, bei der die Abmessungen in beiden seitlichen Richtungen im wesentlichen gleich den seitlichen Abmessungen des Chips mit der integrierten Schaltung oder größer als diese sind und die eine Dicke von 25 bis 125 $\mu$m hat;

(3) des gleichzeitigen Vorheizens der Oberflächen sowohl des Substrats als auch des Chips mit der integrierten Schaltung, so daß die Temperatur wenigstens einer der Oberflächen den Wert $T_g$ des amorphen Klebstoffs überschreitet;

(4) des Positionierens der Klebeauflage auf der erhitzten Substrat-Oberfläche unter Einwirkenlassen von leichtem Druck, um einen Wärmeübergang von dem Substrat zu der Klebeauflage zu bewirken und auf diese Weise den Klebstoff zu erweichen, ohne den Klebstoff zum Fließen zu bringen;

(5) des Positionierens des Chips mit der integrierten Schaltung auf die erhitzte Klebeauflage;

(6) des Laminierens des Chips mit der integrierten Schaltung auf das Substrat durch Einwirkenlassen eines höheren Druck auf den Chip mit der integrierten Schaltung, um innerhalb von 5 Sekunden die Dicke der Klebeauflage um 0,5 bis 5 % zu verringern; und

(7) des Beendigens der Druckeinwirkung auf den Chip mit der integrierten Schaltung und des Abkühlens der laminierten Chipmontage.

**2.** Verfahren nach Anspruch 1, worin die Klebeauflage während des Schrittes (6) der Einwirkung eines Scheuerns in Form eines Musters ausgesetzt wird.

**3.** Verfahren nach Anspruch 1, worin das Substrat und der Chip mit der integrierten Schaltung mittels direkter Wärmeübertragung aus inerten heißen Gasen erhitzt werden.

**4.** Verfahren nach Anspruch 1, worin ein metallischer Leiterrahmen als Substrat verwendet wird.

**5.** Verfahren nach Anspruch 1, worin ein keramisches Oxid als Substrat verwendet wird.

**6.** Verfahren nach Anspruch 5, worin Aluminiumoxid als keramisches Oxid verwendet wird.

EP 0 285 051 B1

7. Verfahren nach Anspruch 1, worin ein organisches Polymer als Substrat verwendet wird.

8. Verfahren nach Anspruch 7, worin ein glas-gefülltes Epoxy-Polymer als Substrat verwendet wird.

9. Verfahren nach Anspruch 1, worin der Klebstoff aus einem nachgiebigen Polymer mit niedrigem Zugmodul im ungefüllten Zustand, einem $T_g$-Wert unter 140 °C und einer Viskosität von weniger als 1 MPa•s bei der Laminierungs-Temperatur besteht.

10. Verfahren nach Anspruch 1, worin der Klebstoff aus einem starren Polymer mit hohem Zugmodul im ungefüllten Zustand, einem $T_g$-Wert von wenigstens 140 °C, einem $T_m$-Wert von wenigstens 230 °C und einer Viskosität von weniger als 5000 Pa•s bei der Laminierungs-Temperatur besteht.

11. Verfahren nach den Ansprüchen 9 und 10, worin der Klebstoff aus einem Gemisch aus einem nachgiebigen Polymer und einem starren Polymer besteht.

12. Verfahren nach Anspruch 1, worin der Klebstoff mit feinen Teilchen {die kleiner als 127 μm (5 mil) sind} eines wärmeleitfähigen Feststoffs gefüllt ist.

13. Verfahren nach Anspruch 12, worin der wärmeleitfähige Feststoff metallisches Silber ist.

14. Verfahren nach Anspruch 1, worin der Klebstoff aus Polyarylaten, Polyetheretherketonen, Polyetherketonketonen, Polyetherimiden, Nylon-Polymeren und -Copolymeren, Polycarbonaten, Polyphenylenoxiden, Polyestern und Copolymeren, Copolymeren von Butadien und Styrol, Copolymeren von Butadien und Acrylnitril, Copolymeren von Butadien und Acrylaten oder Methacrylaten, Copolymeren von Styrol und Acrylaten oder Methacrylaten und deren kompatiblen Gemischen ausgewählt sind.

**Revendications**

1. Un procédé pour fixer une puce à circuits intégrés sur une surface correspondante d'un substrat à haute énergie superficielle, au moyen d'une couche d'un polymère organique thermoplastique, qui comprend dans l'ordre les étapes consistant:
    (1) à former un filament continu d'un polymère thermoplastique, exempt de solvant, essentiellement amorphe, non oléfinique, dont au moins une dimension est sensiblement supérieure ou égale à une dimension latérale de la puce à circuits intégrés, le polymère étant en outre caractérisé en ce que sa température de transition vitreuse $T_g$ est d'au moins 30°C,
    que sa température de fragilisation $T_b$ est inférieure à -30°C,
    que l'absorption d'eau à l'équilibre $S_w$, mesurée à 23°C pendant 24 heures, est inférieure à 1,0% en poids; et
    que la quantité de composés inoniques extractibles est inférieure à 10 ppm en poids;
    (2) à découper le filament pour former un plot adhésif dont les deux dimensions latérales sont sensiblement supérieures ou égales aux dimensions latérales de la puce à circuits intégrés, et dont l'épaisseur est de 25 à 125 μm;
    (3) à préchauffer simultanément la surface du substrat et celle de la puce à circuits intégrés, pour que la température d'au moins l'une des surfaces dépasse la Tg de l'adhésif amorphe;
    (4) à positionner le plot adhésif au-dessus de la surface du substrat chauffé, en appliquant une légère pression pour procéder à un transfert de chaleur du substrat au plot adhésif, de façon à ramollir l'adhésif sans provoquer un écoulement de ce dernier;
    (5) à positionner la puce à circuits intégrés sur le plot adhésif chauffé;
    (6) à contrecoller la puce à circuits intégrés sur le substrat en appliquant une pression supérieure sur la puce à circuits intégrés, pour réduire l'épaisseur du plot adhésif de 0,5-5% en 5 secondes; et
    (7) à supprimer la pression appliquée sur la puce à circuits intégrés et à refroidir l'ensemble de la puce stratifiée.

2. Le procédé selon la revendication 1, dans lequel le plot adhésif est soumis pendant l'étape 6 à une action de frottement structurée.

3. Le procédé selon la revendication 1, dans lequel le substrat et la puce à circuits intégrés sont chauffés par un transfert direct de chaleur à partir de gaz chauds inertes.

12

**4.** Le procédé selon la revendication 1, dans lequel on utilise comme substrat une grille de connexion métallique

**5.** Le procédé selon la revendication 1, dans lequel on utilise comme substrat un oxyde céramique.

**6.** Le procédé selon la revendication 5, dans lequel on utilise comme oxyde céramique de l'alumine.

**7.** Le procédé selon la revendication 1, dans lequel on utilise comme substrat un polymère organique.

**8.** Le procédé selon la revendication 7, dans lequel on utilise comme substrat un polymère époxyde chargé de verre.

**9.** Le procédé selon la revendication 1, dans lequel l'adhésif est constitué d'un polymère souple ayant un faible module d'élasticité en traction à l'état non chargé, une $T_g$ inférieure à 140°C et une viscosité inférieure à 1M Pa.s à la température de contrecollage.

**10.** Le procédé selon la revendication 1, dans lequel l'adhésif est constitué d'un polymère rigide ayant un module d'élasticité en traction élevé à l'état non chargé, une $T_g$ d'au moins 140°C, une $T_m$ d'au moins 230°C et une viscosité inférieure à 5000 Pa.s à la température de contrecollage.

**11.** Procédé selon les revendications 9 et 10, dans lequel l'adhésif est constitué d'un mélange de polymères rigides et souples.

**12.** Le procédé selon la revendication 1, dans lequel l'adhésif est chargé de particules finement divisées inférieures à 127 $\mu$m (5 mils) de solides thermoconducteurs.

**13.** Le procédé selon la revendication 12, dans lequel les solides thermoconducteurs sont constitués d'argent métallique.

**14.** Le procédé selon la revendication 1, dans lequel l'adhésif est choisi parmi les polyarylates, polyétheréthercétones, les polyéthercétonecétones, les polyétherimides, les polymères et copolymères du nylon, les polycarbonates, les poly(oxydes de phénylène), les polyesters et copolyesters, les copolymères du butadiène et du styrène, les copolymères du butadiène et de l'acrylonitrile, les copolymères du butadiène et d'acrylates ou de méthacrylates, les copolymères du styrène et d'acrylates ou méthacrylates et leurs mélanges compatibles.

*Fig. 1*

*Fig. 2*

EP 0 285 051 B1